# EUROPÄISCHE PATENTSCHRIFT

(11) **EP 4 062 456 B1**
(45) Veröffentlichungstag und Bekanntmachung des Hinweises auf die Patenterteilung: **12.02.2025**
(21) Anmeldenummer: 20842175.0
(22) Anmeldetag: 18.11.2020
(51) Int. Cl.: H01L 31/042, H01L 31/044

(54) **SOLARMODUL**
SOLAR MODULE
MODULE SOLAIRE

(30) Priorität: 20.11.2019 DE 102019131354
(43) Veröffentlichungstag der Anmeldung: 28.09.2022
(73) Patentinhaber: Hanwha Q CELLS GmbH, 06766 Bitterfeld-Wolfen (DE)
(72) Erfinder: GERBIG, Christian, 06766 Bitterfeld-Wolfen (DE); KÜHNE, Marcel, 06766 Bitterfeld-Wolfen (DE); METTE, Michael, 06766 Bitterfeld-Wolfen (DE)
(74) Vertreter: adares Patent- und Rechtsanwälte Reininger & Partner GmbB
(86) Internationale Anmeldenummer: PCT/DE2020/100977
(87) Internationale Veröffentlichungsnummer: WO 2021/098916

(56) Entgegenhaltungen:
- EP-A1- 3 959 748
- GB-A- 2 564 123
- US-A1- 2017 170 336

## Beschreibung

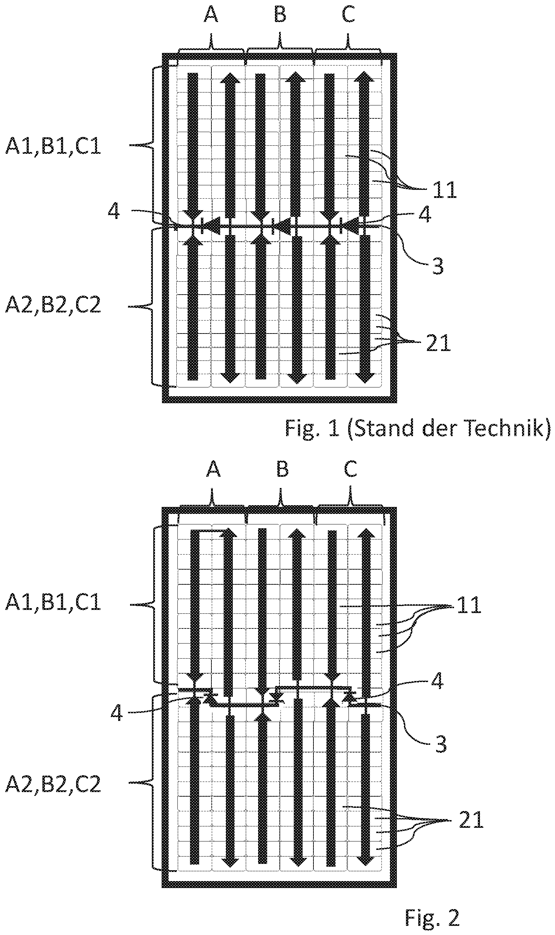

Die Erfindung betrifft ein Solarmodul. Insbesondere betrifft die Erfindung ein Solarmodul mit mindestens zwei Substring-Gruppen. Ein solches Solarmodul ist aus einem nicht druckschriftlich belegten Stand der Technik bekannt, der in Fig. 1 gezeigt ist.

Fig. 1 zeigt das Solarmodul, das eine Substring-Gruppe A, eine Substring-Gruppe B und eine Substring-Gruppe C aufweist. Jede Substring-Gruppe A,B,C weist einen oberen Substring A1,B1,C1 mit einer Anzahl in Reihe geschalteter Solarzellen 11 auf. Die Anzahl N der in Reihe geschalteten Solarzellen 11 kann beliebig sein, jedoch muss N ≥ 2 sein um eine Verschaltung gewährleisten zu können. Die Solarzellen 11 der oberen Substrings A1,B1,C1 sind in einer Matrixform aus zwei benachbarten Spalten mit beispielhaft zwölf Zeilen angeordnet, wobei die Solarzellen 11 als vierundzwanzig so genannte Halbzellen ausgebildet sind, da sie nach Fertigung der Solarzelle in zwei Hälften geschnitten worden sind. Jede Substring-Gruppe A,B,C weist weiterhin einen unteren Substring A2,B2,C2 mit einer Anzahl in Reihe geschalteter Solarzellen 21 auf. Die Solarzellen 21 sind ebenfalls in einer Matrixform aus zwei benachbarten Spalten und zwölf Zeilen angeordnet, wobei die Solarzellen 21 auch als vierundzwanzig Halbzellen ausgebildet sind. Der untere Substring A2,B2,C2 und der obere Substring A1,B1,C1 weisen die gleiche Anzahl an Solarzellen 11,21 auf, die beide parallel zueinander verschaltet sind. Intern sind pro Substring A1,B1,C1,A2,B2,C2 jeweils vierundzwanzig Solarzellen 11,21 in Form von Halbzellen in Reihe verschaltet. Insgesamt sind somit sechsmal vierundzwanzig Halbzellen im Solarmodul miteinander verschaltet.

Das Solarmodul weist weiterhin einen Querverbinder 3 auf, der jeweils den unteren Substring A2,B2,C2 und den oberen Substring A1,B1,C1 elektrisch parallel zu der Substring-Gruppe A,B,C verschaltet. Die Querverbinder 3 jeder Substring-Gruppe A,B,C sind so miteinander kontaktiert, dass die Substring-Gruppen A,B,C elektrisch seriell miteinander verschaltet sind. Die Querverbinder 3 sind mittig im Solarmodul angeordnet.

Das Solarmodul weist weiterhin drei Bypass-Dioden 4 auf, die elektrisch im Querverbinder 3 angeordnet sind. Jede Bypass-Diode 4 ist jeweils einer der Substring-Gruppen A,B,C zugeordnet und schützt jeweils zweimal vierundzwanzig Solarzellen 11,21 modulintern.

Die Querverbinder 3 und die Bypass-Dioden 4 sind jeweils mittig platziert. Durch die Teilung des Solarmoduls in zwei gleich große Hälften durch die Querverbinder 3 und die Bypass-Dioden 4 wirkt sich bei einer hochkantigen Montage des Solarmoduls eine Teilverschattung der unteren Substrings weniger stark aus als bei einem Solarmodul, bei dem die Bypass-Dioden nicht mittig angeordnet sind. Das Solarmodul kann aufgrund der mittig platzierten Bypass-Dioden 4 noch weiterhin bis zu 50% der Leistung produzieren, selbst wenn eine Teilverschattung des Solarmoduls vorliegt. Die Ausdrücke "oberer" und "unterer" Substring sind so zu verstehen, dass die beiden Substrings der Substring-Gruppe derart zueinander angeordnet sind.

Üblicherweise werden Solarmodule mit verschiedenen Längen- und Breitenabmessungen bereitgestellt, um unterschiedlichen Größenanforderungen beispielsweise auf Gebäudedächern oder -fassaden zu entsprechen. Bei dem in Fig. 1 gezeigten Solarmodul-Aufbau ist es jedoch notwendig, die Anzahl an Solarzellen pro Substring-Gruppe um mindestens zwei Zeilen - also eine Zeile pro Substring - zu erhöhen, um die Solarmodul-Größe in vertikaler Richtung zu verändern. Dies liegt daran, dass das Solarmodul nur dann funktionsfähig ist, wenn der untere Substring und der zu diesem elektrisch parallel geschaltete obere Substring der Substring-Gruppe die gleiche Anzahl an gleichen Solarzellen aufweisen.

Bevorzugt wird ein Solarmodul während der Fertigung mit quadratischen oder im Wesentlichen quadratischen Solarzellen bereitgestellt. Derartige Solarzellen sind als Vollzellen ausgebildet, während Halbzellen zwei Hälften einer Vollzelle darstellen, die während der Fertigung in die Hälften geschnitten wurde. Darüber hinaus ist es auch möglich, gefertigte Zellen zu dritteln, zu vierteln oder zu fünfteln und diese Teilzellen zu Solarmodulen zu verbauen. Vollzellen weisen beispielsweise eine Kantenlänge von etwa 156 mm x 156 mm auf, die auch als 6-Zoll- (6"-) Zellen bezeichnet werden. Die Vollzellen können aber auch andere Größen aufweisen.

In dem in Fig. 1 beispielhaft gezeigten Solarmodul sind die Solarzellen 11,21 als Halbzellen bereitgestellt, da sie in zwei Hälften geschnitten sind. Diese Solarzellen 11,12 sind derart angeordnet, dass sich bereits aus ihrer Anordnung eine bestimmte Solarmodul-Größe ergibt. Durch vorbestimmte Abstände zwischen den Halbzellen von beispielsweise 4 bis 5 mm und ggf. Randabstände zu einem Rahmen des Solarmoduls im Bereich von wenigen Zentimetern ergibt sich eine typische Solarmodul-Größe, die eine Standardgröße darstellt.

Je nach der Anzahl der verbauten Solarzellen im Solarmodul ergeben sich daher variierende Solarmodul-Größen mit Standardabmessungen. Die Standardabmessungen ergeben sich insbesondere, da meist drei Substring-Gruppen mit jeweils zwei Spalten pro Substring in einem Solarmodul eingesetzt werden.

So beschreibt GB 2564123 A ein Solarmodul mit drei Substring-Gruppen, das Solarzellen enthält, die in sechs Gruppen von jeweils zwanzig Solarzellen unterteilt sind und mittels einer Verbindung zu Strings ausgebildet sind. Eine Anschlussdose enthält drei Bypass-Dioden und ist über Kabel mit den Strings verbunden. Die Anzahl an Solarzellen, die im oberen Substring angeordnet sind, und die Anzahl an Solarzellen, die im unteren Substring angeordnet sind, ist jeweils gerade.

EP 3 959 748 A1 beschreibt ein Solarmodul mit mehreren Substring-Gruppen, wobei jeder Substring-Gruppe einen oberen Substring und einen unteren Substring aufweist mit je 2 Spalten und mehreren Reihen aufweist. Die Spalten der oberen und unteren Substrings können eine ungerade Anzahl an Solarzellen aufweisen. Die gesamte Struktur ist aus Halbzellen aufgebaut.

Beispielsweise weist das in Fig. 1 gezeigte Solarmodul mit den drei Substring-Gruppen A,B,C und den vierundzwanzig Solarzellen 11,21 pro Substring-Gruppe A1,B1,C1,A2,B2,C2 die Solarzellen 11,12 in Form von Halbzellen mit einer Breite von 156,75 mm, Höhe von 78,38 mm und einer Fläche von 122,16 cm² auf. Die Spalten der Substring-Gruppen A,B,C erstrecken sich dann für 24 Solarzellen pro Substring über etwa 2.000 mm. Bei einem Solarmodul, das dem in Fig. 1 gezeigten Solarmodul entspricht mit dem Unterschied, dass es sechsundzwanzig Solarzellen pro Substring-Gruppe aufweist, erstrecken sich hingegen die Spalten der Substring-Gruppen A,B,C über etwa 2.200 mm. Bei einem Solarmodul, das dem in Fig. 1 gezeigten Solarmodul entspricht mit dem Unterschied, dass es zweiundzwanzig Solarzellen pro Substring-Gruppe aufweist, erstrecken sich dann die Spalten der Substring-Gruppen A,B,C über etwa 1.800 mm.

Ein Solarmodul mit einem vergleichbaren Aufbau zu dem in Fig. 1 gezeigten Solarmodul weist daher Standardabmessungen auf, die je nach Solarzellenanzahl pro Substring und Anzahl an Substring-Gruppen variieren aber aufgrund der Standard-Größe der Solarzellen in seiner Größenänderung relativ fest vorbestimmt ist und bei Änderung der Solarzellen-Anzahl eine relativ große Größenänderung in vertikaler Richtung aufweist.

Es ist jedoch wünschenswert, ein Solarmodul bereitzustellen, das eine feiner granulierte vertikale Größenänderung erlaubt und insbesondere Zwischengrößen aufweist.

Insbesondere wenn das Solarmodul im Aufdach- oder im Architekturbereich beispielsweise als Fassadenelement integrierbar sein soll, ist es wünschenswert die Solarmodul-Größe in relativ fein granulierten Größenänderungen zu verändern. Dies ist weiterhin wünschenswert, um eine Laminatorauslastung im Produktionsprozess zu verbessern, denn Laminatoren weisen oft feststehende Längen- und Breitenabmessungen auf, die derart dimensioniert sind, dass mehrere Solarmodullaminate mit definierten Abmessungen gemeinsam in einem Laminator laminiert werden, damit auf diese Weise der Durchsatz erhöht werden kann. Es wird versucht, die Fläche im Laminator mit möglichst vielen benachbart angeordneten Solarmodullaminaten auszufüllen. Wenn sich die Maße der Solarmodullaminate in vergleichsweise groben Abstufungen ändern, ist schneller der Zustand erreicht, dass weniger benachbarte Solarmodullaminate im Laminator prozessiert werden können.

Es ist daher eine Aufgabe der Erfindung, ein Solarmodul bereitzustellen, das eine feiner granulierte vertikale Größenänderung erlaubt. Diese Aufgabe wird gelöst durch ein Solarmodul mit den Merkmalen des Anspruchs 1.

Erfindungsgemäß ist vorgesehen, dass zwei Spalten des unteren Substrings eine unterschiedliche Anzahl an Solarzellen aufweisen und dass zwei Spalten des in der Substring-Gruppe zugehörigen oberen Substrings eine unterschiedliche Anzahl an Solarzellen aufweisen, so dass die Anzahl der Solarzellen des oberen Substrings und die Anzahl der Solarzellen des unteren Substrings ungerade ist.

Durch diesen Aufbau lässt sich die Substring-Gruppe in vertikaler Richtung um eine Zeile Solarzellen erhöhen, so dass diese Größenänderung des Solarmoduls im Vergleich zu üblichen Designs halb so groß ist. Dadurch kann eine kleinere Änderung der vertikalen Solarmodul-Größe erreicht werden als im Stand der Technik. Dadurch werden neue Solarmodul-Größen bereitgestellt, die als Zwischengrößen zwischen bekannten Standardgrößen ausgebildet sind. Dies birgt auch den Vorteil, dass die Laminatoren zum Laminieren der Solarmodullaminate Platzeffizienter eingesetzt werden können.

In einer bevorzugten Ausführungsform sind der obere Substring und der in der Substring-Gruppe zugehörige untere Substring derart eingerichtet und ausgebildet, dass diese bei gleicher Beleuchtung die gleiche elektrische Spannung generieren. Unter der Formulierung "die gleiche elektrische Spannung" ist die gleiche elektrische Spannung innerhalb von Messfehlertoleranzen zu verstehen. Wenn der obere und der untere Substring einer Substring-Gruppe bei gleicher Beleuchtung nicht ausgelegt sind, die gleiche elektrische Spannung zu generieren, werden Ausgleichsströme fließen, die das Solarmodul funktionsunfähig oder zumindest unrentabel machen.

Bevorzugt weisen die oberen Substrings und die unteren Substrings jeweils Solarzellen mit gleichen Abmessungen auf, die in zwei benachbarten Spalten angeordnet sind. Dadurch können die Substrings die Solarmodulfläche effizient ausfüllen.

Die Solarzellen sind als Vollzellen ausgebildet. Die Größe der einzelnen Vollzelle hängt unter anderem vom Herstellungsverfahren der Solarzelle ab. Beispielsweise beträgt die Größe einer Siliziumwafer-Vollzelle 156 mm x 156 mm, d.h. die Vollzelle ist eine sogenannte 6-Zoll- (6"-) Zelle. Bevorzugt sind die Vollzellen quadratisch oder im Wesentlichen quadratisch ausgebildet.

In einer nicht-erfindungsgemäßen Ausführungsform sind die Solarzellen als Halbzellen ausgebildet. Halbzellen sind Solarzellen, die nach ihrer Fertigung in Form von Vollzellen in zwei Hälften geschnitten sind. Durch die Zellteilung erhöht sich eine Gesamtfläche der Zellzwischenräume auf der Solarmodulfläche im Vergleich zu einer Gesamtfläche der Zellzwischenräume bei entsprechenden Solarzellen, die nicht geteilt sind. Dies bewirkt einen höheren Reflexionsgewinn über die Rückseitenfolie. Weiterhin wird eine Reduzierung elektrischer Leitungsverluste durch einen halbierten Strom pro Substring und eine höhere Zahl von Zellverbindern erzielt. Durch die Ausbildung der Solarzellen als Halbzellen, ist weiterhin eine feiner granulierte Größenänderung des Solarmoduls erreichbar als bei der Ausbildung der Solarzellen als Vollzellen, wenn in den Substrings Solarzellen hinzugefügt oder weggelassen werden. Über die nicht-erfindungsgemäße Ausbildung als Halbzellen hinaus ist es auch möglich, gefertigte Zellen zu dritteln, zu vierteln oder zu fünfteln und diese Teilzellen jeweils zu Solarmodulen zu verbauen.

Bevorzugt sind mindestens zwei Substring-Gruppen elektrisch in Serie miteinander verschaltet. Bevorzugter sind drei Substring-Gruppen elektrisch in Serie miteinander verschaltet. Bevorzugt sind die Solarzellen des Solarmoduls in sechs Spalten angeordnet, d.h. jeder der drei Substring-Gruppen weist zwei Spalten auf.

Die seriell miteinander verschalteten Substring-Gruppen können derart ausgebildet sein, dass diese jeweils bei Beleuchtung unterschiedliche elektrische Spannungen generieren. In einer bevorzugten Ausführungsform sind die Substring-Gruppen derart ausgebildet, dass diese bei gleicher Beleuchtung jeweils eine gleiche Spannung generieren.

Bevorzugt ist jeder Substring-Gruppe im Bereich der elektrischen Parallelverschaltung zwischen dem zugehörigen oberen Substring und dem zugehörigen unteren Substring jeweils eine Bypass-Diode zugeordnet. Dadurch kann auch im Falle einer Teilverschattung der Solarmoduloberfläche deutlich mehr Leistung generiert werden als ohne den Einsatz von Bypass-Dioden.

Bevorzugt weisen alle Substring-Gruppen die gleiche Anzahl an Solarzellen auf. Dadurch wird ein Solarmodul bereitgestellt, das sich auf einfache Weise rechteckig ausbilden lässt. Somit sind die üblicherweise quadratisch oder rechteckig ausgebildeten Solarzellen raumsparend in einem rechteckigen Solarmodul angeordnet.

In einer bevorzugten Ausführungsform weist eine der Substring-Gruppen eine andere Anzahl an Solarzellen auf als die andere Substring-Gruppe oder die anderen Substring-Gruppen. Dadurch kann das Solarmodul an eine gewünschte Geometrie angepasst sein.

Bevorzugt sind die Solarzellen als Siliziumwafer-Solarzellen ausgebildet. Aus diesen lassen sich auf einfache Weise die nicht-erfindungsgemäßen Halbzellen schneiden.

Ein Ausführungsbeispiel der Erfindung ist in den Zeichnungen rein schematisch dargestellt und wird nachfolgend näher beschrieben. Es zeigen rein schematisch und nicht maßstabsgerecht
Fig. 1 eine Draufsicht auf ein Solarmodul gemäß Stand der Technik; und
Fig. 2 eine Draufsicht auf ein erfindungsgemäßes Solarmodul.

Fig. 1 zeigt eine Draufsicht auf ein Solarmodul gemäß Stand der Technik und ist bereits in der Beschreibungseinleitung erläutert worden. Es wird daher zur Vermeidung von Wiederholungen auf die vorstehende Beschreibung verwiesen.

Fig. 2 zeigt eine Draufsicht auf ein erfindungsgemäßes Solarmodul. Das in Fig. 2 gezeigte Solarmodul entspricht dem in Fig. 1 gezeigten Solarmodul mit dem Unterschied, dass alle Solarzellen 11,21 als Vollzellen ausgebildet sind und zwei Spalten des unteren Substrings A2,B2,C2 eine unterschiedliche Anzahl an Solarzellen 21 aufweisen und dass zwei Spalten des in der Substring-Gruppe A,B,C zugehörigen oberen Substrings A1,B1,C1 eine unterschiedliche Anzahl an Solarzellen 11 aufweisen, so dass die Anzahl der Solarzellen 11 des oberen Substrings A1,B1,C1 und die Anzahl der Solarzellen 21 des unteren Substrings A2,B2,C2 jeweils ungerade ist.

Die unteren Substrings A2,B2,C2 und die obere Substrings A1,B1,C1 weisen jeweils die gleiche Anzahl an Solarzellen 11,21 auf. Die Solarzellen 11 der oberen Substrings A1,B1,C1 und die Solarzellen 21 der unteren Substrings A2,B2,C2 sind jeweils in einer Matrixform aus zwei benachbarten Spalten und mehreren Zeilen angeordnet, wobei die Solarzellen 11 und die Solarzellen 21 jeweils als dreiundzwanzig Vollzellen pro Substring A1,B1,C1,A2,B2,C2 ausgebildet sind. Intern sind pro Substring A1,B1,C1,A2,B2,C2 jeweils dreiundzwanzig Solarzellen 11,21 in Form von Vollzellen in Reihe verschaltet. Insgesamt sind somit sechs x dreiundzwanzig Solarzellen 11,21 im Solarmodul parallel geschalten.

Das Solarmodul weist weiterhin die Querverbinder 3 auf, die jeweils den unteren Substring A2,B2,C2 und den oberen Substring A1,B1,C1 elektrisch parallel zu der Substring-Gruppe A,B,C verschalten. Die Querverbinder 3 verlaufen in der elektrischen Schaltungsführung jedoch mäandrierend im Solarmodul. Jede Bypass-Diode 4 ist jeweils einer der Substring-Gruppen A,B,C zugeordnet und schützt jeweils zweimal dreiundzwanzig Solarzellen 11,21 modulintern.

### Bezugszeichenliste:

- A1: oberer Substring der Substring-Gruppe A
- A2: unterer Substring der Substring-Gruppe A
- A: Substring-Gruppe A1+A2
- B1: oberer Substring der Substring-Gruppe B
- B2: unterer Substring der Substring-Gruppe B
- B: Substring-Gruppe B1+B2
- C1: oberer Substring der Substring-Gruppe C
- C2: unterer Substring der Substring-Gruppe C
- C: Substring-Gruppe C1+C2
- 11: Solarzellen der oberen Substrings
- 21: Solarzellen der unteren Substrings
- 3: Querverbinder
- 4: Bypass-Dioden

## Patentansprüche

1. Solarmodul mit mindestens zwei Substring-Gruppen (A,B,C), jede Substring-Gruppe (A,B,C) aufweisend
- einen oberen Substring (A1,B1,C1) mit einer Anzahl in Reihe geschalteter Solarzellen (11), wobei die Solarzellen (11) der oberen Substrings (A1,B1,C1) in einer Matrixform aus mindestens zwei benachbarten Spalten und mehreren Zeilen angeordnet sind,
- einen unteren Substring (A2,B2,C2) mit einer Anzahl in Reihe geschalteter Solarzellen (21), wobei die Solarzellen (21) in einer Matrixform aus mindestens zwei benachbarten Spalten und mehreren Zeilen angeordnet sind und wobei der untere Substring (A2,B2,C2) und der obere Substring (A1,B1,C1) die gleiche Anzahl an Solarzellen (11,21) aufweisen und
- einen Querverbinder (3) der den unteren Substring (A2,B2,C2) und den oberen Substring (A1,B1,C1) elektrisch parallel zu der Substring-Gruppe (A,B,C) verschaltet und
- eine Bypass-Diode (4), die elektrisch im Querverbinder (3) angeordnet ist,
wobei die Querverbinder (3) jeder Substring-Gruppe (A,B,C) so miteinander kontaktiert sind, dass die Substring-Gruppen (A,B,C) elektrisch seriell miteinander verschaltet sind, wobei die Solarzellen (11,21) als Vollzellen ausgebildet sind,
**dadurch gekennzeichnet, dass**
zwei Spalten des unteren Substrings (A2,B2,C2) eine unterschiedliche Anzahl an Solarzellen (21) aufweisen und dass zwei Spalten des in der Substring-Gruppe (A,B,C) zugehörigen oberen Substrings (A1,B1,C1) eine unterschiedliche Anzahl an Solarzellen (11) aufweisen, so dass die Anzahl der Solarzellen (11) des oberen Substrings (A1,B1,C1) und die Anzahl der Solarzellen (21) des unteren Substrings (A2,B2,C2) ungerade ist.

2. Solarmodul nach Anspruch 1, **dadurch gekennzeichnet, dass** der obere Substring (A1,B1,C1) und der in der Substring-Gruppe (A,B,C) zugehörige untere Substring (A2,B2,C2) derart eingerichtet und ausgebildet sind, dass diese bei gleicher Beleuchtung die gleiche elektrische Spannung generieren.

3. Solarmodul nach Anspruch 1 oder 2, **dadurch gekennzeichnet, dass** die oberen Substrings (A1,B1,C1) und die unteren Substrings (A2,B2,C2) jeweils Solarzellen (11,21) mit gleichen Abmessungen aufweisen, die in zwei benachbarten Spalten angeordnet sind.

4. Solarmodul nach einem der Ansprüche 1 bis 3, **dadurch gekennzeichnet, dass** die Solarzellen (11,21) als Halbzellen ausgebildet sind.

5. Solarmodul nach einem der vorangehenden Ansprüche, **dadurch gekennzeichnet, dass** mindestens zwei Substring-Gruppen (A,B,C) elektrisch in Serie miteinander verschaltet sind.

6. Solarmodul nach einem der vorangehenden Ansprüche, **dadurch gekennzeichnet, dass** die Substring-Gruppen (A,B,C) derart ausgebildet sind, dass diese jeweils eine gleiche Spannung oder unterschiedliche elektrische Spannungen generieren.

7. Solarmodul nach einem der vorangehenden Ansprüche, **dadurch gekennzeichnet, dass** jeder Substring-Gruppe (A,B,C) im Bereich der elektrischen Parallelverschaltung zwischen dem zugehörigen oberen Substring (A1,B1,C1) und dem zugehörigen unteren Substring (A2,B2,C2) jeweils eine Bypass-Diode (4) zugeordnet ist.

8. Solarmodul nach einem der vorangehenden Ansprüche, **dadurch gekennzeichnet, dass** alle Substring-Gruppen (A,B,C) die gleiche Anzahl an Solarzellen (11,21) aufweisen.

9. Solarmodul nach einem der Ansprüche 1 bis 7, **dadurch gekennzeichnet, dass** eine der Substring-Gruppen (A,B,C) eine andere Anzahl an Solarzellen aufweist als die andere Substring-Gruppe (A,B,C) oder die anderen Substring-Gruppen (A,B,C).

10. Solarmodul nach einem der vorangehenden Ansprüche, **dadurch gekennzeichnet, dass** die Solarzellen (11,21) als Siliziumwafer-Solarzellen ausgebildet sind.

## Claims

1. A solar module having at least two substring groups (A,B,C), each substring group (A,B,C) comprising
- an upper substring (A1,B1,C1) having a number of solar cells (11) that are connected in series, wherein the solar cells (11) of the upper substring (A1,B1,C1) are arranged in a matrix form comprising at least two adjacent columns and multiple rows,
- a lower substring (A2,B2,C2) having a number of solar cells (21), that are connected in series, wherein the solar cells (21) are arranged in a matrix form comprising at least two adjacent columns and multiple rows and wherein the lower substring (A2,B2,C2) and the upper substring (A1,B1,C1) have the same number of solar cells (11,21) and
- a transverse connector (3) electrically connects the lower substring (A2,B2,C2) and the upper substring (A1,B1,C1) in parallel to form the substring group (A,B,C) and
- a bypass diode (4) that is electrically arranged in the transverse connector (3),
wherein the transverse connector (3) of each substring group (A,B,C) are in contact with one another in such a manner that the substring groups (A,B,C) are electrically connected to one another in series, wherein the solar cells (11, 21) are designed as full cells,
**characterized in that**
two columns of the lower substring (A2,B2,C2) have a different number of solar cells (21) and that two columns of the associated upper substring (A1,B1,C1) in the substring group (A,B,C) have a different number of solar cells (11) with the result that the number of solar cells (11) of the upper substring (A1,B1,C1) and the number of solar cells (21) in the lower substring (A2,B2,C2) is uneven.

2. The solar module as claimed in claim 1, **characterized in that** the upper substring (A1,B1,C1) and the associated lower substring (A2,B2,C2) in the substring group (A,B,C) are oriented and designed in such a manner that when exposed to the same amount of light they generate the same electrical voltage.

3. The solar module as claimed in claim 1 or 2, **characterized in that** the upper substrings (A1,B1,C1) and the lower substrings (A2,B2,C2) each have solar cells (11,21) that have identical dimensions and are arranged in two adjacent columns.

4. The solar module as claimed in one of claims 1 to 3, **characterized in that** the solar cells (11,21) are designed as half cells.

5. The solar module as claimed in one of the preceding claims, **characterized in that** at least two substring groups (A,B,C) are electrically connected to one another in series.

6. The solar module as claimed in one of the preceding claims, **characterized in that** the two substring groups (A,B,C) are designed in such a manner that they each generate the same voltage or different electrical voltages.

7. The solar module as claimed in one of the preceding claims, **characterized in that** a bypass diode (4) is allocated respectively to each substring group (A,B,C) in the region of the electrical parallel interconnection between the associated upper substring (A1,B1,C1) and the associated lower substring (A2,B2,C2).

8. The solar module as claimed in one of the preceding claims, **characterized in that** all substring groups (A,B,C) have the same number of solar cells (11,21).

9. The solar module as claimed in one of claims 1 to 7, **characterized in that** one of the substring groups (A,B,C) has a different number of solar cells than the other substring group (A,B,C) or the other substring groups (A,B,C).

10. The solar module as claimed in one of the preceding claims, **characterized in that** the solar cells (11,21) are designed as silicon wafer solar cells.

## Revendications

1. Un module solaire avec au moins deux groupes de sous-chaînes (A, B, C), chaque groupe de sous-chaînes (A, B, C) ayant
- une sous-chaîne supérieure (A1,B1,C1) avec un nombre de cellules solaires connectées en série (11), dans lequel les cellules solaires (11) des sous-chaînes supérieures (A1,B1,C1) sont disposées sous une forme matricielle d'au moins deux colonnes adjacentes et de plusieurs rangées,
- une sous-chaîne inférieure (A2, B2, C2) contenant un nombre de cellules solaires connectées en série (21), dans lequel les cellules solaires (21) sont disposées sous une forme matricielle d'au moins deux colonnes adjacentes et de plusieurs rangées, et dans lequel la sous-chaîne inférieure (A2, B2, C2) et la sous-chaîne supérieure (A1, B1, C1) ont le même nombre de cellules solaires (11, 21), et
- un connecteur transversal (3) qui relie électriquement la sous-chaîne inférieure (A2,B2,C2) et la sous-chaîne supérieure (A1,B1,C1) parallèlement pour former le groupe de sous-chaînes (A,B,C) et
- une diode de dérivation (4), qui est disposée électriquement dans le connecteur transversal (3),
dans lequel les connecteurs transversaux (3) de chaque groupe de sous-chaînes (A, B, C) sont en contact les uns aux autres de telle manière que les groupes de sous-chaînes (A, B, C) sont électriquement reliés les uns aux autres en série, dans lequel les cellules solaires sont formées comme des cellules complètes,
**caractérisé en ce que**
deux colonnes de la sous-chaîne inférieure (A2,B2,C2) ont un nombre différent de cellules solaires (21) et que deux colonnes de la sous-chaîne supérieure (A1,B1,C1) appartenant au groupe de sous-chaînes (A,B,C) ont un nombre différent de cellules solaires (11), de sorte que le nombre de cellules solaires (11) de la sous-chaîne supérieure (A1,B1,C1) et le nombre de cellules solaires (21) de la sous-chaîne inférieure (A2, B2,C2) est impair.

2. Le module solaire selon la revendication 1, **caractérisé en ce que** la sous-chaîne supérieure (A1,B1,C1) et la sous-chaîne inférieure (A2,B2,C2) appartenant au groupe des sous-chaînes (A,B,C) sont installées et conçues de telle manière qu'elles génèrent la même tension électrique sous le même éclairage.

3. Le module solaire selon la revendication 1 ou 2, **caractérisé en ce que** les sous-chaînes supérieures (A1,B1,C1) et les sous-chaînes inférieures (A2,B2,C2) ont chacune des cellules solaires (11,21) de dimensions égales disposées en deux colonnes adjacentes.

4. Le module solaire selon l'une quelconque des revendications 1 à 3, **caractérisé en ce que** les cellules solaires (11, 21) sont formées comme des demi-cellules.

5. Le module solaire selon l'une quelconque des revendications précédentes, **caractérisé en ce qu'**au moins deux groupes de sous-chaînes (A, B, C) sont reliés électriquement l'un à l'autre en série.

6. Le module solaire selon l'une quelconque des revendications précédentes, **caractérisé en ce que** les groupes de sous-chaînes (A, B, C) sont formés de telle sorte qu'ils génèrent chacun une tension égale ou des tensions électriques différentes.

7. Le module solaire selon l'une quelconque des revendications précédentes, **caractérisé en ce qu'**à chaque groupe de sous-chaînes (A,B,C) dans la région de l'interconnexion électrique parallèle entre la sous-chaîne supérieure correspondante (A1,B1,C1) et la sous-chaîne inférieure correspondante (A2,B2,C2) est attribuée une diode de dérivation (4).

8. Le module solaire selon l'une quelconque des revendications précédentes, **caractérisé en ce que** tous les groupes de sous-chaînes (A,B,C) ont le même nombre de cellules solaires (11,21).

9. Le module solaire selon l'une quelconque des revendications 1 à 7, **caractérisé en ce que** l'un des groupes de sous-chaînes (A, B, C) possède un nombre de cellules solaires différent de celui de l'autre groupe de sous-chaînes (A, B, C) ou des autres groupes de sous-chaînes (A, B, C).

10. Le module solaire selon l'une quelconque des revendications précédentes, **caractérisé en ce que** les cellules solaires (11, 21) sont formées comme des cellules solaires à plaquettes de silicium.
